Europäisches Patentamt

European Patent Office

Office européen des brevets

(19)

(11) Veröffentlichungsnummer: **0 266 842 B1**

# (12) EUROPÄISCHE PATENTSCHRIFT

(45) Veröffentlichungstag der Patentschrift: **07.10.92**

(21) Anmeldenummer: **87202116.7**

(22) Anmeldetag: **03.11.87**

(51) Int. Cl.⁵: **H05K 5/00**, H01R 13/506

(54) Rastverbindung.

(30) Priorität: **05.11.86 DE 8629518 U**

(43) Veröffentlichungstag der Anmeldung:
**11.05.88 Patentblatt 88/19**

(45) Bekanntmachung des Hinweises auf die
Patenterteilung:
**07.10.92 Patentblatt 92/41**

(84) Benannte Vertragsstaaten:
**AT DE FR GB**

(56) Entgegenhaltungen:
**DE-A- 3 346 243**
**DE-C- 3 427 936**
**FR-A- 2 545 285**

**IBM TECHNICAL DISCLOSURE BULLETIN,**
**Band 27, Nr. 5, Oktober 1984, Seiten**
**2803-2804; D.E. FEEMAN et al.: "Top cover**
**snap fit"**

(73) Patentinhaber: **N.V. Philips' Gloeilampenfa-**
**brieken**
**Groenewoudseweg 1**
**NL-5621 BA Eindhoven(NL)**

(72) Erfinder: **van der Meer, Johannes Anne**
**c/o INT. OCTROOIBUREAU B.V. Prof. Holst-**
**laan 6**
**NL-5656 AA Eindhoven(NL)**

(74) Vertreter: **Gorter, Willem Karel et al**
**INTERNATIONAAL OCTROOIBUREAU B.V.**
**Prof. Holstlaan 6**
**NL-5656 AA Eindhoven(NL)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Rastverbindung zwischen Gehäuseteilen eines elektrischen Gerätes mit mindestens einem, mit einem ersten Gehäuseteil verbundenen Verriegelungshaken, der jeweils in ein mit einem zweiten Gehäuseteil verbundenes Rastelement eingreift, wobei jeder Verriegelungshaken und jedes Rastelement zum Ein- bzw. Ausrasten elastisch verschiebbar ist, und mit einem Anschlag für jeden Verriegelungshaken um ein unbeabsichtigtes Ausrasten zu verhindern.

Es ist bekannt (DE-PS 3,427,936) Gehäuseteile über eine Rastverbindung mit dem Gehäuse eines elektrischen Gerätes lössbar zu verbinden. Damit die Rastverbindung über die Lebensdauer des Geräts erhalten bleibt wird der Verriegelungshaken über einen Gummipuffer gegen das Rastelement gedrückt. Nach dem Entfernen des Gummipuffers kann die Rastverbindung gelösst werden. Bei handhabbaren elektrischen Geräten wie beispielsweise elektrische Rasierapparaten kann der Gummipuffer die Handlichkeit des Gerätes beeinträchtigen. Er kann aber auch in unbeabsichtigter Weise während des Betriebes entfernt werden. Ein unbeabsichtiges Lösen ist somit nicht auszuschliessen und durch die dann freiliegenden stromführenden elektrischen Komponenten ist eine Unfallgefahr gegeben. Insbesondere kann dies beispielsweise dann der Fall sein, wenn derartige Geräte in die Hände von Kindern gelangen.

Eine Rastverbindung gemäß dem Oberbegriff des Anspruches 1 ist aus DE-A-3 346 243 bekannt.

Der Erfindung liegt die Aufgabe zugrunde, eine Rastverbindung für elektrische Geräte der genannten Art so auszubilden, dass ein Lösen der Rastverbindung in einfacher Weise infolge der Elastizität der Verriegelungshaken und des Rastelementes möglich ist, aber ein unsachgemässer Lösung der Verbindung beispeilsweise durch spielende Kinder, verhindert ist.

Diese Aufgabe wird gelöst durch eine Rastverbindung gemäß dem kennzeichnenden Teil des Anspruches 1.

Mit Hilfe eines von aussen eingeführten Werkzeuges in den Hohlraum sind Verriegelungshaken und Rastelement in einfacher Weise gegeneinander zum Ausrasten verschiebbar.

Die Zugänglichkeit des Hohlraumes kann dabei z.B. über Durchgangsöffnungen mit kleinem Durchmesser in einer Gehäusewand unauffällig gestaltet sein.

Bei entsprechender Elastizität des Verriegelungshakens und des Rastelementes reicht es zum Entrasten aus, dass der Querschnitt eines in den Hohlraum greifenden Werkzeuges in Ausrastrichtung etwas grösser ist als der Hohlraum.

Es kann aber auch vorteilhaft sein, dass der Hohlraum einen, sich verjüngenden Endabschnitt wie bspw. einen sich zu einer Durchgangsöffnung vergrössernden keilförmigen Abschnitt aufweist. Durch die Anlage eines von aussen eingeführten Werkzeuges an den keilförmigen Abschnitt sind Verriegelungshaken und Rastelement in einfacher Weise gegeneinander zum Ausrasten verschiebbar.

Es hat sich weiterhin als vorteilhaft herausgestellt, dass jedes Rastelement eine Durchgangsöffnung für einen Abschnitt des Verriegelungshakens aufweist. Die Rastverbindung ist dadurch in einfacher Weise herstellbar.

Bei einer besonders vorteilhaften Ausführungsform erstrecken sich Verriegelungshaken und Rastelemente mit den zugehörigen Führungsabschnitten jeweils im wesentlichen unter einem rechten Winkel von der Wand des ersten beziehungsweise des zweiten Gehäuseteils. Die Rastverbindung ist dadurch einfach herstellbar.

Es ist ferner vorteilhaft, dass jeder Verriegelungshaken mit dem jeweils zugehörigen Anschlag einstückig an dem ersten Gehäuseteil ausgebildet ist. Das erste Gehäuseteil ist dabei in einfacher Weise mit dem ihm zugeordneten Teil der Rastverbindung herstellbar. Dies gilt entsprechend für das zweite Gehäuseteil, wenn jedes Rastelement mit dem jeweils zugehörigen Anschlag mit ihm ausgebildet ist.

Bei einer weiteren bevorzugten Ausführungsform ist jeder Anschlag als Einführöffnung für die Aufnahme in Richtung zu dem benachbarten Verriegelungshaken beziehungsweise Rastelement abgeschrägt. Die Rastverbindung ist dadurch einfach einrastbar, weil durch die Einführöffnung eine Führung der Führungsabschnitte der Verriegelungshaken und der Rastelemente in die entsprechende Aufnahme gegeben ist.

In besonders vorteilhafter Weise weist zum Herstellen eine sicherer Rastverbindung das erste Gehäuseteil zwei im Abstand voneinander angeordnete Verriegelungshaken auf, deren jeweils in Rastelemente eingreifenden Abschnitte voneinander abgewandt sind, und das zweite Gehäuseteil weist zur Herstellung von zwei Rastverbindungen zwei Rastelemente auf.

Ein Ausführungsbeispiel der Erfindung ist nachfolgend anhand der Zeichnung erläutert. Es zeigen:

Figue 1 eine vereinfachte und schematische Darstellung eines ersten und eines zweiten Gehäuseteiles vor dem Einrasten im Längsschnitt,

Figur 2 eine teilweise Schnittansicht nach der Linie II-II in Figur 1, und

Figur 3 eine schematische Darstellung eines Werkzeugs zum Ausrasten.

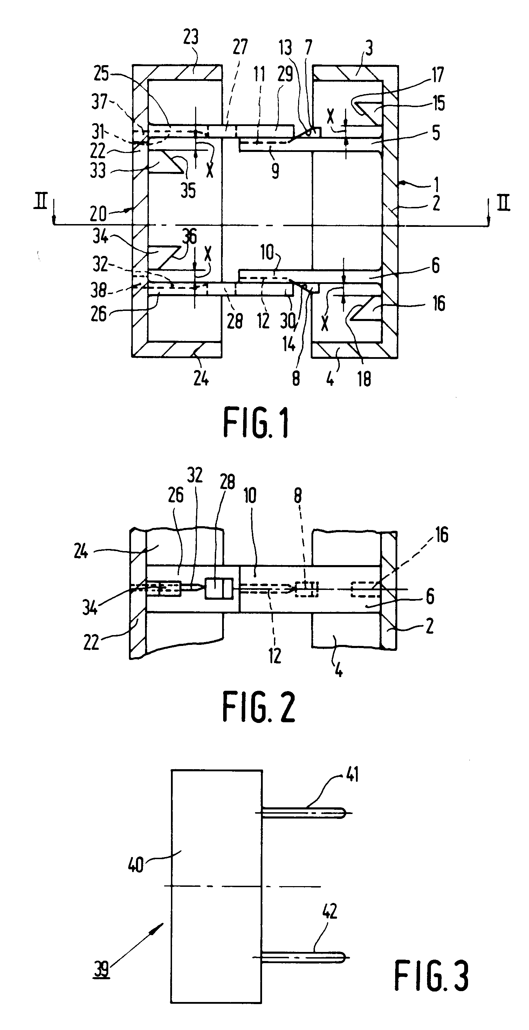

Ein erstes Gehäuseteil 1 (Figuren 1 und 2) hat bspw. als Teil eines Gehäuses für einen elektrischen Rasierapparat im wesentlichen die Form einer Hälfte eines Hohlzylinders mit einer Mantelwand 2 und sich im rechten Winkel davon erstreckenden, halbkreisförmigen Endflächen 3 und 4. Im gleichen Abstand von jeder Endfläche 3, 4 erstreckt sich radial einwärts von der Mantelwand 2 je ein freistehender und elastischer Verriegelungshaken 5 beziehungsweise 6. Jeder der beiden, gleichförmig ausgebildeten Verriegelungshaken 5, 6 weist einen rechteckförmigen Querschnitt auf und liegt im wesentlichen in einer zu den Endflächen 3, 4 parallelen Ebene.

Etwa in der Mitte jedes Verriegelungshakens 5, 6 ist an den einander angewandten Seitenflächen jeweils ein Riegel 7, 8 ausgebildet, der in Richtung zu der jeweils benachbarten Endfläche 3 beziehungsweise 4 ragt. Die Verlängerung jedes Verriegelungshakens 5, 6 über den Riegel 7 beziehungsweise 8 hinaus bildet einen Führungsabschnitt 9, 10. Vom freien Ende jedes Verriegelungshakens 5, 6 her ist an diesem jeweils eine Aussparung 11, 12 ausgebildet, die gegenüber den freien Ende eines Verriegelungshakens 5, 6 und den einander abgewandten Flächen der Verriegelungshaken 5, 6 offen ist und sich radial auswärts im wesentlichen jeweils bis zu einem Riegel 7, 8 erstreckt. Jede Aussparung 11, 12 endet dabei im wesentlichen in einer ihr zugewandten schrägen Fläche 13 bzw. 14 die an dem Riegel 7 beziehungsweise 8 ausgebildet ist. Zwischen jedem Verriegelungshaken 5, 6 und der benachbarten Endwand 3 bzw. 4 erstreckt sich von der Mantelwand 2 jeweils ein Anschlag 15, 16 jeweils im Abstand x von dem benachbarten Verriegelungshaken 5 bzw. 6. Jeder Anschlag 15, 16 weist zu dem benachbarten Verriegelungshaken 5, 6 eine Abschrägung 17 bzw. 18 auf.

Ein zweites Gehäuseteil 20 hat bspw. für einen elektrischen Rasierapparat wie das erste Gehäuseteil 1 im wesentlichen die Gestalt einer Hälfte eines Hohlzylinders mit einer Mantelwand 22 und sich davon im rechten Winkel erstreckenden Endwänden 23 und 24 die nach dem Verbinden der beiden Gehäuseteile 1, 20 jeweils in einer Ebene liegen, und die jeweils nicht dargestellte Ausschlüsse oder Öffnungen bspw. für Rasierelemente und elektrische Verbindungen aufweisen können. Im gleichen Abstand von den Endwänden 23, 24 erstrecken sich radial einwärts freistehende elastische Rastelemente 25, 26. Die beiden gleich ausgebildeten Rastelemente 25, 26 haben einen rechteckförmigen Querschnitt und verlaufen in zu den Endflächen 23 und 24 und damit auch zu den Verriegelungshaken 5, 6 parallel verlaufenden Ebenen. Etwa in der Mitte jedes Rastelementes 25, 26 ist eine in Bezug auf die Mantelwand 22 axial verlaufende Durchgangsöffnung 27, 28 ausgebildet. Der über jeweils eine Durchgangsöffnung 27, 28 ragende Teil eines Rastelementes 25 beziehungsweise 26 ist als Führungsabschnitt 29 beziehungsweise 30 ausgebildet. An den einander zugewandten Flächen der Rastelemente 25, 26 sind zu der jeweiligen Fläche hin offene Aussparungen 31 und 32 ausgebildet. Die Aussparungen 31, 32 reichen bis zur Mantelwand 22 und enden in radial einwärtiger Richtung im wesentlichen an den Durchgangsöffnungen 27 und 28 und laufen mit einer im wesentlichen schrägen Fläche aus. Von den einander zugewandten Flächen der Rastelemente 25, 26 durch einen Abstand x getrennt, ist jedem Rastelement 25, 26 ein Anschlag 33, 34 zugeordnet. Jeder Anschläge 33, 34 erstreckt sich von der Mantelwand 22 im wesentlichen in der gleichen Richtung wie die Rastelemente 25, 26 und weist jeweils zu dem benachbarten Rastelemente 25, 26 eine Abschrägung 35 beziehungsweise 36 auf.

Zum Einrasten werden die beiden, in Figur 1 in einer Lage vor dem Einrasten dargestellten beiden Gehäuseteile 1, 20 in radialer Richtung aufeinander zubewegt. Dabei befinden sich die beiden Verriegelungshaken 5, 6 zwischen den Rastelementen 25, 26. Bei sich verkleinerndem Abstand zwischen den beiden Gehäuseteilen 1, 20 kommen die Führungsabschnitte 29, 30 der Rastelemente 25, 26 in Berührung mit den schrägen Flächen 13 und 14 der Riegel 7 beziehungsweise 8, sodass jeweils ein Verriegelungshaken 5, 6 und das dazugehörige Rastelemente 25, 26 elastisch voneinander bewegt werden. Nach dem Verriegeln, d.h. dem Eingreifen der Riegel 7, 8 in jeweils eine Durchgangsöffnung 27 beziehungsweise 28 kehren die Verriegelungshaken 7, 8 und die Rastelemente 25, 26 jeweils im wesentlichen in ihre unverformte Ausgangslage zurück, in der Verriegelungshaken 5, 6 und Rastelemente 25, 26 in im wesentlichen parallelen Ebenen liegen. Die Führungsabschnitte 29, 30 greifen dabei in den eine Aufnahme bildender Zwischenraum ein der jeweils zwischen einem Anschlag 15 bzw. 16 und dem benachbarten Verriegelungshaken 5 bzw. 6 gebildet ist. Das Einführen der Führungsabschnitte 29, 30 wird dabei durch die Abschrägungen 17, 18 erleichtert. In entsprechender Weise greifen nach dem Einrasten die Führungsabschnitte 9 und 10 der Verriegelungshaken 5 und 6 in die Aufnahmen bilden den Zwischenräume zwischen jeweils einem Rastelement 25, 26 und dem benachbarten Anschlag 33, 34 ein. Das Eingreifen wird dabei gleicherweise durch die Abschrägungen 35 und 36 erleichtert. Der Abstand x ist so bemessen, dass ausser dem für das Einrasten erforderlichen Spiel für die jeweiligen Führungsabschnitte 9, 10, 29 und 30 diese in den Aufnahmen keinen Bewegungsraum haben. Dadurch wird ein unbeabsichtigtes Ausrasten, bspw. infolge von Relativverschiebungen der Gehäuseteile 1, 20 aufgrund eines Herunterfallens des Gerätes oder infolge unsachgemässer Behandlung verhindert. infolge der Festlegung sowohl der Verriegelungshaken 5, 6 als auch der Rastelemente 25, 26 können selbst grosse Relativverschiebungen zwischen den Gehäuseteilen 1, 20 zu keinem ausrasten führen.

In der eingerasteten Stellung kommen jeweils Aussparungen 11 und 31 sowie 12 und 32 nebeneinander zu liegen, sodass Hohlräume geschaffen werden, die radial einwärts in im wesentlichen keilförmigen Abschnitten enden. In radial auswärtiger Richtung sind die Hohlräume über mit ihnen im wesentlichen koaxial verlaufende Durchgangsöffnungen 37, 38 in der Mantelwand 22 nach aussen offen.

Um die beiden Gehäuseteile 1, 20 nach dem Einrasten in gewollter Weise auszurasten bspw. zu Reparatur- oder Wartungszwecken braucht lediglich von aussen über die Durchgangsöffnungen 37, 38 in die durch die Aussparungen 11 und 31 beziehungsweise 12 und 32 gebildeten Hohlräume eingegriffen werden, um jeweils die Verriegelungshaken 5, 6 und die Rastelemente 25, 26 voneinander zu bewegen.

Mittels eines Werkzeuges kann somit in die Hohlräume zum Lösen der Verbindung eingegriffen werden. Die Durchmesser der hierfür vorgesehenen Durchgangsöffnungen 37, 38 können klein gehalten werden um ein unsachgemässes Eingreifen, bspw. durch spielenden Kinder in die Hohlräume zu vermeiden.

Zum einfachen Lösen der Rastverbindung kann bspw. ein in Fig. 2 dargestelltes Werkzeug 39 eingesetzt werden. Dieses weist einen Griff 40 auf und zwei sich davon in wesentlichen im rechten Winkel erstreckende Stössel 41, 42. Diese sind im gleichen Abstand wie die Durchgangsöffnungen 37, 38 angeordnet, sodass sie über diese in die durch die Aussparungen 11 und 31 beziehungsweise 12 und 32 gebildeten Hohlräume eingreifen können. Über die Stössel 41, 42 sind die Verriegelungshaken 5, 6 und die Rastelemente 25, 26 zum Ausrasten gegeneinander verschiebbar. Die Stössel 41, 42 weisen hierfür einen Querschnitt auf dessen Abmessung in Bewegungsrichtung zum Ausrasten grösser als die des Hohlraumes ist, sodass die Riegel 7, 8 und die Durchgangsöffnungen 27, 28 durch elastische Verschiebung der Verriegelungshaken 5, 6 und der Rastelemente 25, 26 ausser Eingriff gebracht werden. Die gegenseitige Verschiebung der Verriegelungselemente 5, 6 und der Rastelemente 25, 26 kann durch den Kontakt der freien Ende der Stössel 41, 42 mit den im wesentlichen keilförmigen Endabschnitten der Hohlräume erleichtert werden.

Um die Gehäuseteile 1 und 20 für die Rastverbindung einfach herzustellen können die Verriegelungshaken 5, 6 und die Anschläge 15, 16 einstückig bspw. aus einem Kunststoffmaterial mit dem ersten Gehäuseteil 1 ausgebildet sein, und es können gleichermassen die Rastelemente 25, 26 und die Anschläge 33, 34 einstückig mit dem zweiten Gehäuseteil 20 einstückig hergestellt sein. Desgleichen können zur herstellung eines einfachen Werkzeugs 39 die Stössel 41 und 42 einstückig mit dem Griff 40 ausgebildet sein.

**Patentansprüche**

1. Rastverbindung zwischen Gehäuseteilen (1, 20) eines elektrischen Geräts mit mindestens einem, mit einem ersten Gehäuseteil (1) verbundenen Verriegelungshaken (5, 6) der jeweils in ein mit einem zweiten Gehäuseteil (20) verbundenes Rastelement (25, 26) eingreift, wobei jeder Verriegelungshaken (5, 6) und jedes Rastelement (25, 26) zum Ein- bzw. Ausrasten elastisch verschiebbar ist, und mit einem Anschlag (33, 34) für jeden Verriegelungshaken (5, 6), um ein unbeabsichtigtes Ausrasten zu verhindern, wobei an dem zweiten Gehäuseteil (20) mit Abstand (x) zu jedem Rastelement (25, 26) jeweils ein Anschlag (33, 34) für einen Verriegelungshaken (5, 6) ausgebildet ist, dadurch gekennzeichnet, dass an dem ersten Gehäuseteil (1) mit Abstand (x) zu jedem Verriegelungshaken (5, 6) jeweils ein weiterer Anschlag (15, 16) für ein Rastelement (25, 26) ausgebildet ist, und dass an einander zugewandten Flächen der Verriegelungshaken (5, 6) und Rastelemente (25, 26) Aussparungen (11, 12; 31, 32) ausgebildet sind, die nach dem Einrasten einen von aussen zugänglichen Hohlraum bilden, durch den jeweils ein Verriegelungshaken (5, 6) und ein Rastelement (25, 26) zum Ausrasten gegeneinander bewegbar sind.

2. Rastverbindung nach Anspruch 1 dadurch gekennzeichnet, dass der Hohlraum einen sich verjüngenden Endabschnitt aufweist.

**Claims**

1. A snap-lock connection between housing parts (1, 20) of an electrical apparatus, comprising at least one latching hook (5, 6) connected to a first housing part (1) and arranged to engage in a latching element (25, 26) connected to a second housing part (20), each latching hook (5, 6) and each latching element (25, 26) being elastically movable into and out of latching engagement, and a stop (33, 34) for each latching hook (5, 6) to preclude inadvertent disengagement, a stop (33, 34) for a latching hook (5, 6) being formed on the second housing part (20) at a distance (x) from each latching element (25, 26), characterised in that at a distance (x) from each latching hook (5, 6) a further stop (15, 16) for a latching element (25, 26) is formed on the first housing part (1), and facing surfaces of the latching hooks (5, 6) and the latching elements 25, 26) are formed with recesses (11, 12; 31, 32) which after latching engagement constitute an externally accessible cavity *via* which a latching hook (5, 6) and a latching element (25, 26) are movable relative to one another out of latching engagement.

2. A snap-lock connection as claimed in Claim 1, characterized in that the cavity has a narrowed end portion.

**Revendications**

1. Assemblage à encliquetage de parties de boîtier (1, 20) d'un appareil électrique, comportant au moins un crochet de verrouillage (5, 6) relié à une première partie de boîtier (1) et s'engageant chaque fois dans un élément d'arrêt (25, 26) relié à une seconde partie de boîtier (20), chaque crochet de verrouillage (5, 6) et chaque élément d'arrêt (25, 26) pouvant être déplacés élastiquement pour l'encliquetage et le décliquetage, ainsi qu'une butée (33, 34) pour chaque crochet de verrouillage (5, 6), servant à éviter un décliquetage par inadvertance, la seconde partie de boîtier (20) étant munie d'une butée (33, 34) pour chaque crochet de verrouillage (5, 6), butées qui sont séparées chacune par une distance (x) de chaque élément d'arrêt (25, 26), caractérisé en ce que la première partie de boîtier (1) présente une autre butée (15, 16) pour un élément d'arrêt (25, 26), butées qui sont séparée chacune par une distance (x) de chaque crochet de verrouillage (5, 6) et en ce que, sur des faces opposées des crochets de verrouillage (5, 6) et des éléments d'arrêt (25, 26), sont pratiqués des évidements (11, 12; 31, 32) qui, après l'encliquetage, forment une cavité accessible de l'extérieur et à travers laquelle on peut déplacer entre eux les crochets de verrouillage (5, 6) d'une part et les éléments d'arrêt (25, 26) d'autre part pour assurer le décliquetage.

2. Assemblage à encliquetage selon la revendication 1, caractérisé en ce que la cavité présente une partie terminale qui va en diminuant.

FIG.1

FIG.2

FIG.3